# EUROPÄISCHE PATENTSCHRIFT

(11) **EP 1 627 208 B1**
(45) Veröffentlichungstag und Bekanntmachung des Hinweises auf die Patenterteilung: **30.07.2008**
(21) Anmeldenummer: 04718179.7
(22) Anmeldetag: 06.03.2004
(51) Int. Cl.: G01D 11/24, G01N 27/22, G01K 1/14

(54) **ABDECKUNG FÜR EINEN AUF EINER LEITERPLATTE ANGEORDNETEN TAUPUNKTSENSOR**
COVER FOR A DEW POINT SENSOR MOUNTED ON A PRINTED CIRCUIT BOARD
ELEMENT DE RECOUVREMENT POUR DETECTEUR DE POINT DE CONDENSATION DISPOSE SUR UNE CARTE DE CIRCUIT

(30) Priorität: 16.05.2003 DE 10322017
(43) Veröffentlichungstag der Anmeldung: 22.02.2006
(73) Patentinhaber: Sitronic Ges. Für Elektrotechnische Ausrüstung Mbh & Co. Kg, 71116 Gärtringen (DE)
(72) Erfinder: LEGL, Stefan, 70771 Leinfelden-Echterdingen (DE); STAUSS, Gerold, 71083 Herrenberg (DE)
(74) Vertreter: Kohler Schmid Möbus
(86) Internationale Anmeldenummer: PCT/DE2004/000445
(87) Internationale Veröffentlichungsnummer: WO 2004/104523

(56) Entgegenhaltungen:
- WO-A-02/33395
- US-A- 3 548 633
- US-A- 5 932 875
- US-B1- 6 344 791
- US-B1- 6 354 153
- PATENT ABSTRACTS OF JAPAN Bd. 1995, Nr. 10, 30. November 1995 (1995-11-30) & JP 7 191116 A (CHODENDO SENSOR KENKYUSHO:KK), 28. Juli 1995 (1995-07-28)

## Beschreibung

Eine bekannte Sensoreinheit weist einen Luftfeuchtesensor zur Messung der relativen Luftfeuchte und einen Lufttemperatursensor zur Messung der Lufttemperatur auf. Wird Luft mit einer bestimmen absoluten Feuchte abgekühlt, steigt die relative Feuchte an, bis sie einen Wert von 100% erreicht. Die Temperatur bei der die relative Feuchte 100% ist, wird als Kondensationspunkt oder Taupunkt bezeichnet. Sinkt die Temperatur weiter bzw. steigt der absolute Wassergehalt an, kondensiert Wasser. Der Taupunkt kann aus der gemessenen relativen Luftfeuchte und der gemessenen Lufttemperatur errechnet werden. Derartige Sensoreinheiten werden in vielen Bereichen der Technik, insbesondere als Beschlagschutz verwendet.

Gemäß der Lehre der WO 02/33395 kann eine Klimakapselung auf der Leiterplatte zum Schutz der Sensoreinheit gegen Umwelteinflüsse hinzugefügt werden. Diese kann ein- oder beidseitig aus klimadurchlässigem Material realisiert werden. Bei nur einseitig klimadurchlässiger Kapselung kann das zweite Schutzelement aus jedem nicht klimadurchlässigen Material realisiert werden.

Der Anmelder hat sich die Aufgabe gestellt, die Kapselung zu verbessern.

Diese Aufgabe wird durch eine Sensoreinheit gemäß Patentanspruch 1 gelöst, wobei eine Dichtlippe für eine optimierte entsprechende Abdichtung sorgt. Diese wird zusätzlich verbessert, weil die Dichtlippe an der Abdeckung umlaufend ausgebildet ist.

Zur Erleichterung der Montage der Abdeckung weist die Leiterplatte eine umlaufende Nut zum Einstecken eines unteren Randes der Abdeckung auf.

Die Position der Abdeckung wird vorgegeben. Die Abdeckung kann vorfixiert werden.

Für den Einsatz bei einer Sensoreinheit zur Bestimmung der Luftfeuchte weist die Abdeckung einen Wandteil und eine mit dem Wandteil verbundene feuchtedurchlässige, insbesondere luftfeuchtedurchlässige Membran auf.

Ein Ausführungsbeispiel der erfindungsgemäßen Sensoreinheit ist in der schematischen Zeichnung dargestellt und wird in der nachfolgenden Beschreibung zur Zeichnung erläutert. Es zeigt:
- **Fig. 1**: eine Sensoreinheit im Querschnitt längs einer Linie I-I gemäß Fig. 2;
- **Fig. 2**: eine Draufsicht eines Teils der Sensoreinheit nach Fig. 1.

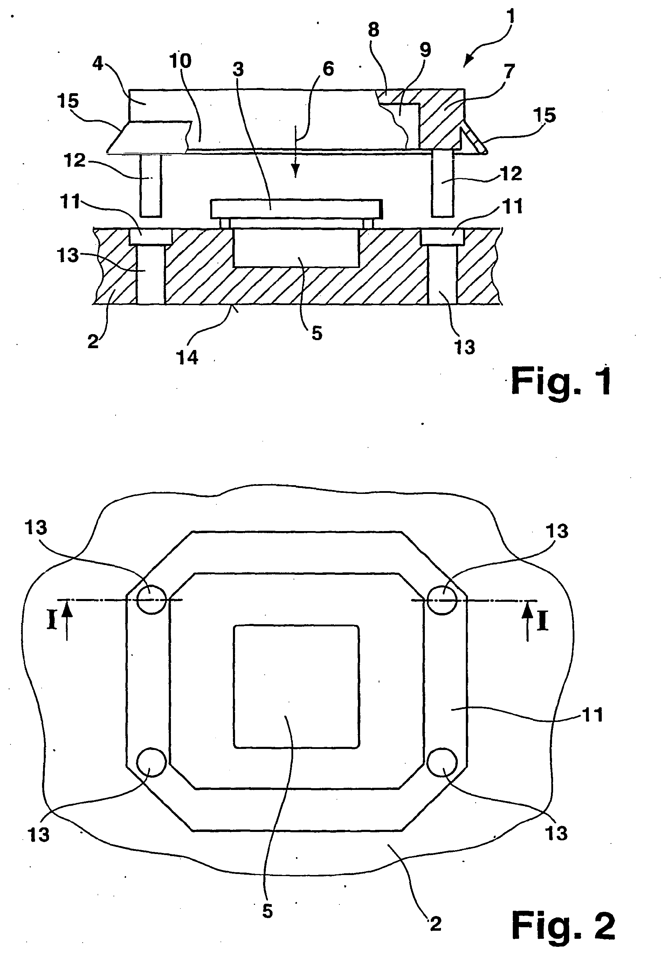

Aus der **Fig. 1** ist ersichtlich, dass eine Sensoreinheit **1** zur Bestimmung des Taupunkts im Wesentlichen eine Leiterplatte **2** als Montagebasis und einen Luftfeuchtesensor **3** und einen in der Figur 1 nicht gezeigten Lufttemperatursensor sowie eine Abdeckung **4** der Sensoren aufweist. Die Sensoren sind zum einen über die Leiterbahnen der Leiterplatte 2 in eine elektrische und/oder elektronische Schaltung integriert. Zum anderen wird durch eine thermisch leitfähige Beschichtung der Leiterplatte 2 realisiert, dass eine gute Wärmeübertragung zwischen den Sensoren möglich ist und kein messbarer Temperaturunterschied am Montageplatz des Lufttemperatursensors und des Luftfeuchtesensors 3 auftritt. Der Luftfeuchtesensor **3** dient der Messung der relativen Luftfeuchte. Der Lufttemperatursensor dient der Messung der Lufttemperatur der zu analysierenden Luft. Weitere auf der Montagebasis 1 befindliche Bauelemente sind der Übersichtlichkeit halber nicht dargestellt.

Der Luftfeuchtesensor 3 umfasst zwei elektrisch leitende Elektroden, zwischen denen sich ein Polymer als Dielektrikum befindet. Die dielektrischen Eigenschaften des Polymers werden von der Luftfeuchte beeinflusst. Es besteht ein eindeutiger Zusammenhang zwischen der relativen Luftfeuchte und dem von dem Polymer molekular aufgenommen Wasser. Der Lufttemperatursensor ist durch einen temperaturabhängigen Widerstand ausgebildet. Daher ist es möglich, mit Hilfe der Kapazitätsmessung am Luftfeuchtesensor 3 und der Widerstandsmessung am Lufttemperatursensor den Taupunkt rechnerisch zu bestimmen.

Die aktive Seite des Luftfeuchtesensors 3 ist über einer Ausnehmung oder Kavität **5** in der Leiterplatte 2 angeordnet. Die Kavität 5 erfüllt zum einen die Funktion, eine möglichst große Fläche, d. h. möglichst die gesamte aktive Seite, des Luftfeuchtesensors. 3 dem Luftgemisch gleichmäßig auszusetzen. Die Kavität 5 bildet zum anderen zusammen mit entsprechenden Luftschlitzen im Gehäuse der Sensoreinheit eine Strömungshilfe, um das zu analysierende Luftgemisch auf den Luftfeuchtesensor 3 zielgerichtet hinzuleiten, und wird derart konstruktiv ausgebildet, so dass gleichzeitig die Leiterplatten-Unterseite **14** als Teil der. Abdichtung genutzt wird. Eventuell zur Leiterbahnführung erforderliche Durchkontaktierungen im Dichtungsbereich der Leiterplatte, werden im Bauteilelötprozess durch Lötung dichtend verschlossen.

Der Luftfeuchtesensor 3 und der Lufttemperatursensor sind durch die Abdeckung 4 abdeckbar, indem die Abdeckung 4 in Abdeckrichtung **6** über die Sensoren gesetzt wird. Die Abdeckung 4 umfasst einen umlaufenden Wandteil **7** und eine luftfeuchtedurchlässige Membran **8** mit einer vorzugsweise selbst reinigenden Oberfläche. Der Hohlraum **9** zwischen Wandteil 7 und Membran 8 ermöglicht die Unterbringung der Sensoren. Der Wandteil 7 weist eine Stärke auf, welche es erlaubt, den unteren Rand **10** des Wandteils 7 in eine umlaufende Nut **11** einzusetzen. Die Nut 11 gibt eine Montage vor und fixiert die Abdeckung 4 bereits geringfügig. Der Wandteil 7 ist mit insgesamt vier Füßen **12** verbunden, welche in Bohrungen **13** einsteckbar sind. Im eingesteckten Zustand ragen die Füße 12 über die Leiterplatten-Unterseite 14 der Leiterplatte 2 geringfügig hinaus und können zusätzlich durch Heißverpressen fixiert werden. Weiterhin liegt eine umlaufende Dichtlippe **15,** welche an den Wandteil 7 angeformt ist und über die Abdeckung 4 zur Leiterplatte 2 etwas vorsteht, im eingesetzten Zustand der Abdeckung 4 auf der Leiterplatte 2 auf, indem die Dichtlippe 15 aus elastischem Kunststoff nach außen gebogen werden kann und dann unter Spannung aufliegt. Dies sorgt für eine für die Applikation klimagerechte Abdichtung. Die Abdeckung 4 erfüllt die Funktion einer Klimakapselung.

### BEZUGSZEICHENLISTE

- 1: Sensoreinheit
- 2: Leiterplatte
- 3: Luftfeuchtesensor
- 4: Abdeckung
- 5: Kavität
- 6: Abdeckrichtung
- 7: Wandteil
- 8: Membran
- 9: Hohlraum
- 10: Rand des Wandteils
- 11: Nut
- 12: Fuß
- 13: Bohrung
- 14: Leiterplatten-Unterseite
- 15: Dichtlippe

## Patentansprüche

1. Sensoreinheit (1) zur Bestimmung des Taupunkts mit einem Lufttemperatursensor und mit zumindest einem Luftfeuchtesensor (3), welcher auf einer Leiterplatte (2) angeordnet ist, und mit einer Abdeckung (4) des Sensors (3), wobei die zur Leiterplatte (2) hin offene Abdeckung (4) auf der Leiterplatte (2) montiert aufliegt, und die Leiterplatten-Unterseite (14) gleichzeitig einen Teil der Abdichtung ausbildet, **dadurch gekennzeichnet, dass** außen an der Abdeckung (4) eine Dichtlippe (15) angebracht ist, welche im aufgesteckten Zustand unter Spannung auf der Leiterplatte (2) dichtend aufliegt.

2. Sensoreinheit nach Anspruch 1, **dadurch gekennzeichnet, dass** die Leiterplatte (2) unterhalb des Sensors (3) eine Ausnehmung oder ein Sackloch aufweist.

3. Sensoreinheit nach Anspruch 1 oder 2, **dadurch gekennzeichnet, dass** die Dichtlippe (15) an der Abdeckung (4) umlaufend ausgebildet ist.

4. Sensoreinheit nach einem der vorhergehenden Ansprüche, **dadurch gekennzeichnet, dass** die Leiterplatte (2) eine umlaufende Nut (11) zum Einstecken eines unteren Randes (10) der Abdeckung (4) aufweist.

5. Sensoreinheit nach einem der vorhergehenden Ansprüche, **dadurch gekennzeichnet, dass** die Abdeckung (4) einen Wandteil (7) und eine mit dem Wandteil (7) verbundene feuchtedurchlässige Membran (8) aufweist.

6. Sensoreinheit nach einem der vorhergehenden Ansprüche, **dadurch gekennzeichnet, dass** die Abdeckung (4) Füße (12) und die Leiterplatte (2) Bohrungen (13) zum Einstecken der Füße (12) aufweist.

## Claims

1. A sensor unit (1) for determining the dew point, comprising an air temperature sensor, at least one air humidity sensor (3) that is arranged on a circuit board (2), and a cover (4) for the sensor (3), wherein the cover (4), which is open towards the circuit board (2), is supported on the circuit board (2) in the installed state, and the underside (14) of the circuit board simultaneously forms part of the seal, **characterized in that** a sealing lip (15) is disposed on the outside of the cover (4), which, in the attached state, is sealingly supported on the circuit board (2) with a certain stress.

2. The sensor unit according to Claim 1, **characterized in that** the circuit board (2) comprises a recess or a blind hole underneath the sensor (3).

3. The sensor unit according to Claim 1 or 2, **characterized in that** the sealing lip (15) extends along the periphery of the cover (4).

4. The sensor unit according to one of the preceding claims, **characterized in that** the circuit board (2) comprises a peripheral groove (11) for inserting a lower edge (10) of the cover (4).

5. The sensor unit according to one of the preceding claims, **characterized in that** the cover (4) comprises a wall section (7) and a membrane (8) that is pervious to humidity and connected to the wall section (7).

6. The sensor unit according to one of the preceding claims, **characterized in that** the cover (4) comprises legs (12) and the circuit board (2) comprises bores (13) for inserting the legs (12).

## Revendications

1. Unité de capteur (1) pour la détermination du point de rosée comprenant un capteur de température de l'air et au moins un capteur d'humidité de l'air (3) qui est disposé sur une carte à circuit imprimé (2), et comprenant un recouvrement (4) du capteur (3), le recouvrement (4) ouvert vers la carte à circuit imprimé (2) étant appliqué, à l'état monté, sur la carte à circuit imprimé (2) et la face inférieure de carte à circuit imprimé (14) formant en même temps une partie de l'étanchéité, **caractérisée en ce qu'**une lèvre d'étanchéité (15) qui, à l'état embroché, est appliquée sous contrainte sur la carte à circuit imprimé (2) de manière à assurer l'étanchéité, est installée extérieurement sur le recouvrement (4).

2. Unité de capteur selon la revendication 1, **caractérisée en ce que** la carte à circuit imprimé (2) présente un évidement ou un trou borgne sous le capteur (3).

3. Unité de capteur selon la revendication 1 ou 2, **caractérisée en ce que** la lèvre d'étanchéité (15) est formée périphériquement sur le recouvrement (4).

4. Unité de capteur selon l'une des revendications précédentes, **caractérisée en ce que** la carte à circuit imprimé (2) présente une rainure périphérique (11) pour l'encastrement d'un bord inférieur (10) du recouvrement (4).

5. Unité de capteur selon l'une des revendications précédentes, **caractérisée en ce que** le recouvrement (4) présente une partie de paroi (7) et une membrane (8) perméable à l'humidité reliée à la partie de paroi (7).

6. Unité de capteur selon l'une des revendications précédentes, **caractérisée en ce que** le recouvrement (4) présente des pieds (12) et la carte à circuit imprimé (2) des trous (13) pour l'encastrement des pieds (12).
